# EUROPEAN PATENT APPLICATION

(11) **EP 4 836 301 A1**
(43) Date of publication of application: **04.11.2026**
(21) Application number: 24923292.7
(22) Date of filing: 03.09.2024
(51) Int. Cl.: H03K 19/003

(54) **LEVEL SHIFTING CIRCUIT, CHIP AND ELECTRONIC DEVICE**

(30) Priority: 06.02.2024 CN 202410168701
(71) Applicant: Huawei Technologies Co., Ltd., Shenzhen, Guangdong 518129 (CN)
(72) Inventor: LI, Mingliang, Shenzhen, Guangdong 518129 (CN)
(74) Representative: Isarpatent
(86) International application number: PCT/CN2024/116659
(87) International publication number: WO 2025/167082

(57) **Abstract**

This application discloses a level shifting circuit, a chip, and an electronic device. The level shifting circuit includes an input/output circuit and a withstand voltage control circuit. The input/output circuit includes a first input switch, a second input switch, a first output control switch, a second output control switch, a first output switch, a second output switch, a third output switch, a fourth output switch, a first selection switch, a second selection switch, a third selection switch, and a fourth selection switch. The first input switch, the second input switch, the first output control switch, the second output control switch, the first output switch, the second output switch, the third output switch, the fourth output switch, the first selection switch, the second selection switch, the third selection switch, the fourth selection switch, and the withstand voltage control circuit cooperate with each other, so that when a power supply voltage input to a second power supply end exceeds an upper limit of a withstand voltage range of a single switch, it is ensured that a switch in the input/output circuit does not experience reliability degradation or failure.

## Description

### CROSS-REFERENCE TO RELATED APPLICATIONS

This application claims priority to Chinese Patent Application No. 202410168701.X, filed with the China National Intellectual Property Administration on February 6, 2024 and entitled "LEVEL SHIFTING CIRCUIT, CHIP, AND ELECTRONIC DEVICE", which is incorporated herein by reference in its entirety.

### TECHNICAL FIELD

This application relates to the field of level shifting technologies, and in particular, to a level shifting circuit, a chip, and an electronic device.

### BACKGROUND

To reduce costs while ensuring a high driving capability, a level shifting circuit (level shifter, LS) is generally used to perform level shifting on a low voltage to implement a high voltage output. Alternatively, a level mismatch problem may occur when different circuits communicate with each other. If a voltage difference between two circuits is excessively large, the circuits may be damaged. In this case, a level shifting circuit is generally disposed between the two circuits, and voltage conversion is performed through the level shifting circuit, so that voltages of the two circuits are consistent.

Generally, the level shifting circuit includes a plurality of switching transistors, to implement a voltage conversion function. However, the switching transistor has a specific withstand voltage range. In addition, with evolution of semiconductor processes, a withstand voltage of the switching transistor gradually decreases. Consequently, during actual operation, a power supply voltage input to the level shifting circuit may be higher than the withstand voltage range of the switching transistor, resulting in reliability degradation or failure of the switching transistor.

### SUMMARY

This application provides a level shifting circuit, a chip, and an electronic device, to avoid reliability degradation or failure of a switching transistor when a power supply voltage input to the level shifting circuit is higher than a withstand voltage range of the switching transistor.

According to a first aspect, an embodiment of this application provides a level shifting circuit, where the level shifting circuit includes an input/output circuit and a withstand voltage control circuit. The input/output circuit includes a first input switch, a second input switch, a first output control switch, a second output control switch, a first output switch, a second output switch, a third output switch, a fourth output switch, a first selection switch, a second selection switch, a third selection switch, and a fourth selection switch, where a control electrode of the first input switch is connected to a first signal input end, a first electrode of the first input switch is connected to a first power supply end, a second electrode of the first input switch is connected to a first electrode of the first selection switch, a second electrode of the first selection switch is connected to a first electrode of the first output switch, a control electrode of the first output control switch is configured to receive a first output control signal, a first electrode of the first output control switch is connected to a second power supply end, a second electrode of the first output control switch is connected to a first electrode of the second selection switch, a second electrode of the second selection switch is connected to a first electrode of the second output switch, a second electrode of the first output switch and a second electrode of the second output switch are both connected to a first signal output end, a control electrode of the second input switch is connected to a second signal input end, a first electrode of the second input switch is connected to the first power supply end, a second electrode of the second input switch is connected to a first electrode of the third selection switch, a second electrode of the third selection switch is connected to a first electrode of the third output switch, a control electrode of the second output control switch is configured to receive a second output control signal, a first electrode of the second output control switch is connected to the second power supply end, a second electrode of the second output control switch is connected to a first electrode of the fourth selection switch, a second electrode of the fourth selection switch is connected to a first electrode of the fourth output switch, a second electrode of the third output switch and a second electrode of the fourth output switch are both connected to a second signal output end, and a control electrode of the first selection switch, a control electrode of the second selection switch, a control electrode of the third selection switch, and a control electrode of the fourth selection switch are all connected to a selection control end. In this way, when a power supply voltage input to the second power supply end exceeds an upper limit of a withstand voltage range of a single switch in the input/output circuit, the first signal output end is pulled down through the first input switch, the first selection switch, and the first output switch, to ensure that the first input switch, the first selection switch, and the first output switch do not experience reliability degradation or failure.

When the power supply voltage input to the second power supply end exceeds the upper limit of the withstand voltage range of the single switch in the input/output circuit, the first signal output end is pulled up through the first output control switch, the second selection switch, and the second output switch, to ensure that the first output control switch, the second selection switch, and the second output switch do not experience reliability degradation or failure.

When the power supply voltage input to the second power supply end exceeds the upper limit of the withstand voltage range of the single switch in the input/output circuit, the second signal output end is pulled down through the second input switch, the third selection switch, and the third output switch, to ensure that the second input switch, the third selection switch, and the third output switch do not experience reliability degradation or failure.

When the power supply voltage input to the second power supply end exceeds the upper limit of the withstand voltage range of the single switch in the input/output circuit, the second signal output end is pulled up through the second output control switch, the fourth selection switch, and the fourth output switch, to ensure that the second output control switch, the fourth selection switch, and the fourth output switch do not experience reliability degradation or failure.

In addition, for the withstand voltage control circuit, a first input end is connected to a first withstand voltage control end, a second input end is connected to the first signal output end, a third input end is connected to the second signal output end, a first output end is connected to a control electrode of the first output switch, a second output end is connected to a control electrode of the second output switch, a third output end is connected to a control electrode of the third output switch, and a fourth output end is connected to a control electrode of the fourth output switch. In addition, the withstand voltage control circuit is configured to: output a voltage at the first withstand voltage control end or the first signal output end to the control electrode of the first output switch, output the voltage at the first withstand voltage control end or the first signal output end to the control electrode of the second output switch, output the voltage at the first withstand voltage control end or the second signal output end to the control electrode of the third output switch, and output the voltage at the first withstand voltage control end or the second signal output end to the control electrode of the fourth output switch. In this way, the withstand voltage control circuit is disposed, so that when the power supply voltage input to the second power supply end exceeds an upper limit of a withstand voltage range of a single switch in the first output switch, the second output switch, the third output switch, and the fourth output switch, voltages of the control electrodes of the first output switch, the second output switch, the third output switch, and the fourth output switch may be adjusted through the withstand voltage control circuit. In this way, a voltage difference between the control electrode and the second electrode of each of the first output switch, the second output switch, the third output switch, and the fourth output switch may be less than or equal to an upper limit of a withstand voltage range of the output switch, to ensure that the first output switch, the second output switch, the third output switch, and the fourth output switch do not experience reliability degradation or failure.

The level shifting circuit in this embodiment of this application may be applied to a scenario in which level shifting is performed on a differential signal. Based on this, signals input to the first signal input end and the second signal input end may be differential signals, so that signals output from the first signal output end and the second signal output end are also differential signals.

In some embodiments, the withstand voltage control circuit includes a first withstand voltage control sub-circuit, a second withstand voltage control sub-circuit, a third withstand voltage control sub-circuit, and a fourth withstand voltage control sub-circuit. For the first withstand voltage control sub-circuit, a first input end is connected to the first withstand voltage control end, a second input end is connected to the first signal output end, and an output end is connected to the control electrode of the first output switch; and the first withstand voltage control sub-circuit is configured to output the voltage at the first withstand voltage control end or the first signal output end to the control electrode of the first output switch in response to voltages at the first withstand voltage control end and the first signal output end. In this way, the first withstand voltage control sub-circuit adjusts a voltage of the control electrode of the first output switch, so that a voltage difference between the control electrode of the first output switch and the first signal output end is less than or equal to an upper limit of a withstand voltage range of the first output switch, to avoid reliability degradation or failure of the first output switch.

In addition, for the second withstand voltage control sub-circuit, a first input end is connected to the first withstand voltage control end, a second input end is connected to the first signal output end, and an output end is connected to the control electrode of the second output switch; and the second withstand voltage control sub-circuit is configured to output the voltage at the first withstand voltage control end or the first signal output end to the control electrode of the second output switch in response to the voltages at the first withstand voltage control end and the first signal output end. In this way, the second withstand voltage control sub-circuit adjusts a voltage of the control electrode of the second output switch, so that a voltage difference between the control electrode of the second output switch and the first signal output end is less than or equal to an upper limit of a withstand voltage range of the second output switch, to avoid reliability degradation or failure of the second output switch.

In addition, for the third withstand voltage control sub-circuit, a first input end is connected to the first withstand voltage control end, a second input end is connected to the second signal output end, and an output end is connected to the control electrode of the third output switch; and the third withstand voltage control sub-circuit is configured to output the voltage at the first withstand voltage control end or the second signal output end to the control electrode of the third output switch in response to voltages at the first withstand voltage control end and the second signal output end. In this way, the third withstand voltage control sub-circuit adjusts a voltage of the control electrode of the third output switch, so that a voltage difference between the control electrode of the third output switch and the second signal output end is less than or equal to an upper limit of a withstand voltage range of the third output switch, to avoid reliability degradation or failure of the third output switch.

In addition, for the fourth withstand voltage control sub-circuit, a first input end is connected to the first withstand voltage control end, a second input end is connected to the second signal output end, and an output end is connected to the control electrode of the fourth output switch; and the fourth withstand voltage control sub-circuit is configured to output the voltage at the first withstand voltage control end or the second signal output end to the control electrode of the fourth output switch in response to the voltages at the first withstand voltage control end and the second signal output end. In this way, the fourth withstand voltage control sub-circuit adjusts a voltage of the control electrode of the fourth output switch, so that a voltage difference between the control electrode of the fourth output switch and the second signal output end is less than or equal to an upper limit of a withstand voltage range of the fourth output switch, to avoid reliability degradation or failure of the fourth output switch.

In some embodiments, the first withstand voltage control sub-circuit includes a first control switch and a second control switch. A control electrode of the first control switch is connected to the first withstand voltage control end, a first electrode of the first control switch is connected to the first signal output end, and a second electrode of the first control switch is connected to the control electrode of the first output switch. In addition, a control electrode of the second control switch is connected to the first signal output end, a first electrode of the second control switch is connected to the first withstand voltage control end, and a second electrode of the second control switch is connected to the control electrode of the first output switch. In this way, a first withstand voltage control sub-circuit with a simple structure can be implemented, so that application is simple, and production costs can be further reduced.

In some embodiments, the second withstand voltage control sub-circuit includes a third control switch and a fourth control switch. A control electrode of the third control switch is connected to the first withstand voltage control end, a first electrode of the third control switch is connected to the first signal output end, and a second electrode of the third control switch is connected to the control electrode of the second output switch. In addition, a control electrode of the fourth control switch is connected to the first signal output end, a first electrode of the fourth control switch is connected to the first withstand voltage control end, and a second electrode of the fourth control switch is connected to the control electrode of the second output switch. In this way, a second withstand voltage control sub-circuit with a simple structure can be implemented, so that application is simple, and production costs can be further reduced.

In some embodiments, the second withstand voltage control sub-circuit further includes a fifth control switch. A control electrode of the fifth control switch is connected to the second withstand voltage control end, a first electrode of the fifth control switch is connected to the first withstand voltage control end, and a second electrode of the fifth control switch is connected to the control electrode of the second output switch. In this way, with reference to turning on and turning off of the fifth control switch, the level shifting level can switch between operating modes in different voltage application scenarios.

In some embodiments, the third withstand voltage control sub-circuit includes a sixth control switch and a seventh control switch. A control electrode of the sixth control switch is connected to the first withstand voltage control end, a first electrode of the sixth control switch is connected to the second signal output end, and a second electrode of the sixth control switch is connected to the control electrode of the third output switch. In addition, a control electrode of the seventh control switch is connected to the second signal output end, a first electrode of the seventh control switch is connected to the first withstand voltage control end, and a second electrode of the seventh control switch is connected to the control electrode of the third output switch. In this way, a third withstand voltage control sub-circuit with a simple structure can be implemented, so that application is simple, and production costs can be further reduced.

In some embodiments, the fourth withstand voltage control sub-circuit includes an eighth control switch and a ninth control switch. A control electrode of the eighth control switch is connected to the first withstand voltage control end, a first electrode of the eighth control switch is connected to the second signal output end, and a second electrode of the eighth control switch is connected to the control electrode of the fourth output switch. In addition, a control electrode of the ninth control switch is connected to the second signal output end, a first electrode of the ninth control switch is connected to the first withstand voltage control end, and a second electrode of the ninth control switch is connected to the control electrode of the fourth output switch. In this way, a fourth withstand voltage control sub-circuit with a simple structure can be implemented, so that application is simple, and production costs can be further reduced.

In some embodiments, the fourth withstand voltage control sub-circuit further includes a tenth control switch. A control electrode of the tenth control switch is connected to the second withstand voltage control end, a first electrode of the tenth control switch is connected to the first withstand voltage control end, and a second electrode of the tenth control switch is connected to the control electrode of the fourth output switch. In this way, with reference to turning on and turning off of the tenth control switch, the level shifting level can switch between operating modes in different voltage application scenarios.

In some embodiments, the level shifting circuit further includes a first connection control circuit and a second connection control circuit. An input end of the first connection control circuit is connected to the second electrode of the first input switch, an output end of the first connection control circuit is connected to the control electrode of the first output switch, and the first connection control circuit is configured to control connection or disconnection between the second electrode of the first input switch and the control electrode of the first output switch. In addition, an input end of the second connection control circuit is connected to the second electrode of the second input switch, an output end of the second connection control circuit is connected to the control electrode of the third output switch, and the second connection control circuit is configured to control connection or disconnection between the second electrode of the second input switch and the control electrode of the third output switch. In this way, with reference to control of the first connection control circuit and the second connection control circuit, the level shifting level can switch between operating modes in different voltage application scenarios.

In some embodiments, the first connection control circuit includes a first connection control switch and a second connection control switch. A control electrode of the first connection control switch is connected to a first connection control end, a first electrode of the first connection control switch is connected to the second electrode of the first input switch, and a second electrode of the first connection control switch is connected to a first electrode of the second connection control switch. In addition, a control electrode of the second connection control switch is connected to a second connection control end, and a second electrode of the second connection control switch is connected to the control electrode of the first output switch. In this way, a first connection control circuit with a simple structure can be implemented, so that application is simple, and production costs can be further reduced.

In some embodiments, the second connection control circuit includes a third connection control switch and a fourth connection control switch. A control electrode of the third connection control switch is connected to the first connection control end, a first electrode of the third connection control switch is connected to a second electrode of the second input switch, and a second electrode of the third connection control switch is connected to the first electrode of the fourth connection control switch. In addition, a control electrode of the fourth connection control switch is connected to the second connection control end, and a second electrode of the fourth connection control switch is connected to the control electrode of the third output switch. In this way, a second connection control circuit with a simple structure can be implemented, so that application is simple, and production costs can be further reduced.

In some embodiments, the first output control signal and the second output control signal may be respectively input through two different ports, or the first output control signal and the second output control signal may be input through a same port.

To reduce a quantity of external ports connected to the level shifting circuit and reduce routing difficulty, in some embodiments, the control electrode of the first output control switch is connected to the control electrode of the third output switch, so that a signal of the control electrode of the third output switch is used as the first output control signal, to control the first output control switch to be turned on or turned off. In addition, the control electrode of the second output control switch is connected to the control electrode of the first output switch, so that a signal of the control electrode of the first output switch is used as the second output control signal, to control the second output control switch to be turned on or turned off. In this way, the control electrode of the first output control switch and the control electrode of the second output control switch do not need to be additionally connected to an external port.

In some embodiments, the first signal input end and the second signal input end are connected to different ports, and the first signal output end and the second signal output end are connected to different ports.

In some embodiments, the level shifting circuit further includes a phase inverter. The first signal input end and an input end of the phase inverter are connected to a same port, the second signal input end is connected to an output end of the phase inverter, and the first signal output end and the second signal output end are connected to different ports. In this way, a quantity of input ends can be reduced.

According to a second aspect, an embodiment of this application further provides a chip. The chip includes an input end circuit, an output end circuit, and a level shifting circuit, and an input end of the level shifting circuit is connected to the input end circuit, and is configured to receive an input voltage from the input end circuit. In addition, an output end of the level shifting circuit is connected to the output end circuit, and is configured to send an output voltage to the output end circuit. The level shifting circuit is the level shifting circuit described in any one of the first aspect or the possible implementations of the first aspect.

According to a third aspect, an embodiment of this application further provides an electronic device. The electronic device includes a circuit board and a chip, and the chip is disposed on the circuit board. The chip is the chip described in any one of the second aspect or the possible implementations of the second aspect.

In addition, for technical effect of the corresponding solutions in the second aspect and the third aspect, refer to technical effect that can be obtained by using the corresponding solutions in the first aspect. Repeated content is not described in detail.

### BRIEF DESCRIPTION OF DRAWINGS

FIG. 1 is a diagram of a structure of an electronic device according to an embodiment of this application;
FIG. 2 is a diagram of a structure of a chip according to an embodiment of this application;
FIG. 3 is a schematic of a circuit structure of a level shifting circuit according to an embodiment of this application;
FIG. 4 is a schematic of another circuit structure of a level shifting circuit according to an embodiment of this application;
FIG. 5 is a schematic of a specific circuit structure of a level shifting circuit according to an embodiment of this application;
FIG. 6 is a signal time sequence diagram according to an embodiment of this application;
FIG. 7 is a schematic of another circuit structure of a level shifting circuit according to an embodiment of this application;
FIG. 8 is a schematic of another specific circuit structure of a level shifting circuit according to an embodiment of this application;
FIG. 9a is another signal time sequence diagram according to an embodiment of this application;
FIG. 9b is another signal time sequence diagram according to an embodiment of this application; and
FIG. 10 is a schematic of another specific circuit structure of a level shifting circuit according to an embodiment of this application.

### DESCRIPTION OF EMBODIMENTS

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that in descriptions of this application, "a plurality of" may be understood as "at least two." In addition, it should be understood that, in the descriptions of this application, terms such as "first" and "second" are merely used for distinguishing and description, cannot be understood as an indication or implication of relative importance, and cannot be understood as an indication or implication of a sequence.

It should be noted that same reference numerals in the accompanying drawings of this application indicate same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

It may be understood that a switch in embodiments of this application may be a switching transistor. For example, the switching transistor includes but is not limited to one or more of a plurality of types of switching devices such as a metal-oxide semiconductor field-effect transistor (metal-oxide semiconductor field-effect transistor, MOSFET), a bipolar junction transistor (bipolar junction transistor, BJT), an insulated gate bipolar transistor (insulated gate bipolar transistor, IGBT), and a silicon carbide (SiC) MOSFET. Examples are not enumerated one by one in embodiments of this application. In addition, each switch may include a first electrode, a second electrode, and a control electrode, and the control electrode is configured to control turning on or turning off of the switch. When the switch is turned on, a current can be transmitted between the first electrode and the second electrode of the switch. When the switch is turned off, no current can be transmitted between the first electrode and the second electrode of the switch. The MOSFET is used as an example. The control electrode of the switch is a gate. The first electrode of the switch may be a source, and the second electrode of the switch may be a drain; or the first electrode may be a drain, and the second electrode may be a source.

To facilitate understanding of the technical solutions provided in embodiments of this application, the following first describes specific application scenarios of the technical solutions.

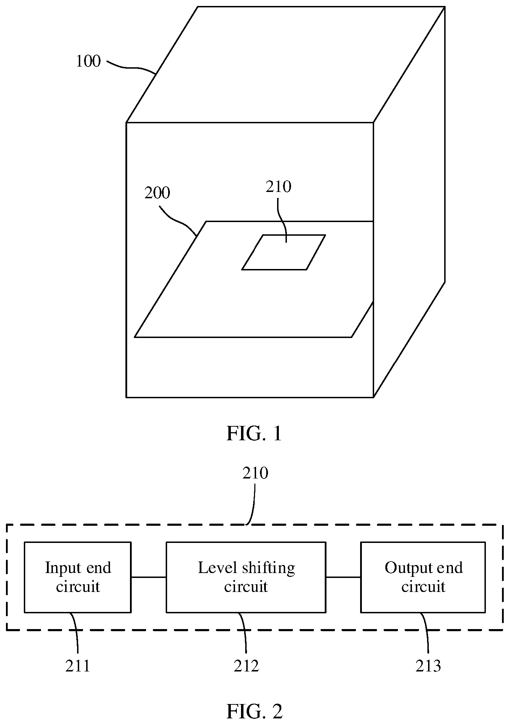

FIG. 1 is a diagram of a structure of an electronic device according to an embodiment of this application. As shown in FIG. 1, in this embodiment of this application, the electronic device includes a housing 100, and a circuit board 200 and a chip 210 that are disposed in the housing 100. The chip 210 is disposed on the circuit board 200. In addition to the chip 210, another electronic device may be further disposed in the circuit board 200. The circuit board 200 may be configured to supply power to the chip 210 and the another electronic device or transmit a signal.

For example, the electronic device may be a computer device having a chip, for example, a server, a desktop computer, or a personal computer, or may be a portable electronic device having a processor chip, for example, a mobile phone, a tablet computer, or a vehicle-mounted device. The chip 210 may be a graphics processing unit (graphics processing unit, GPU), a chip having a logical operation capability like a central processing unit (central processing unit, CPU), an artificial intelligence (artificial intelligence, AI) chip, or a system on chip (system on chip, SoC), or may be a programmable logic device like an analog-to-digital converter, a digital-to-analog converter, an application-specific integrated circuit (application-specific integrated circuit, ASIC), or a field programmable gate array (field programmable gate array, FPGA) of another type, a switch logic device, a hardware component, or any combination thereof. In this embodiment of this application, an example in which the electronic device is a server is used for description. In addition, the circuit board includes, for example, but is not limited to, a printed circuit board (Printed Circuit Board, PCB).

FIG. 2 is a diagram of a structure of a chip according to an embodiment of this application. As shown in FIG. 2, the chip 210 may include an input end circuit 211, an output end circuit 213, and a level shifting circuit (level shifter, LS) 212. An input end of the level shifting circuit 212 is connected to the input end circuit 211, and an output end of the level shifting circuit 212 is connected to the output end circuit 213. During operation, the input end circuit 211 may output a signal. The level shifting circuit 212 receives the signal, performs level shifting on the signal, and outputs the signal to the output end circuit 213. The output end circuit 213 may perform a corresponding operation based on the received signal. For example, the output end circuit 213 may be a buffer (buffer) or another type of circuit.

Generally, the level shifting circuit 212 includes a plurality of switches, to implement a voltage conversion function. For example, the switch is an MOSFET. With evolution of a semiconductor process, a withstand voltage of the MOSFET gradually decreases. For example, the MOSFET evolves from a device with a withstand voltage of 3.3 V and 2.5 V to a device with a withstand voltage of 1.8 V. In an advanced semiconductor process, a withstand voltage of the MOSFET is lower (for example, 1.8 V or even 1.2 V). However, 3.3 V is a common external power supply voltage. If 3.3 V is used as a power supply voltage and is input to the level shifting circuit 212, the power supply voltage exceeds the withstand voltage of the MOSFET. Consequently, the MOSFET (especially an MOSFET connected to a signal output end) may experience reliability degradation or failure. Therefore, embodiments of this application provide a level shifting circuit 212, to avoid the reliability degradation or failure of the MOSFET when the power supply voltage is higher than a withstand voltage range of the MOSFET.

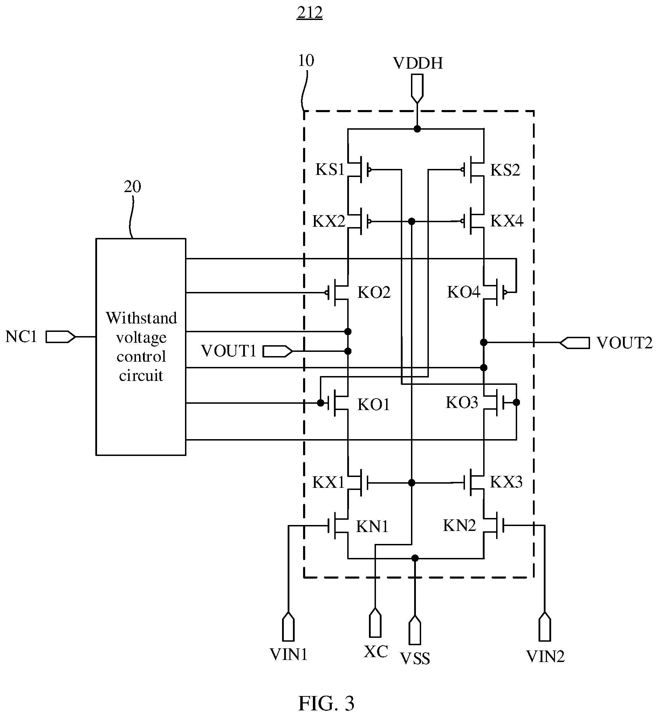

FIG. 3 is a schematic of a circuit structure of the level shifting circuit according to an embodiment of this application. As shown in FIG. 3, the level shifting circuit 212 may include an input/output circuit 10 and a withstand voltage control circuit 20. The input/output circuit 10 includes a first input switch KN1, a second input switch KN2, a first output control switch KS1, a second output control switch KS2, a first output switch KO1, a second output switch KO2, a third output switch KO3, a fourth output switch KO4, a first selection switch KX1, a second selection switch KX2, a third selection switch KX3, and a fourth selection switch KX4. A control electrode of the first input switch KN1 is connected to a first signal input end VIN1, a first electrode of the first input switch KN1 is connected to a first power supply end VSS, a second electrode of the first input switch KN1 is connected to a first electrode of the first selection switch KX1, a second electrode of the first selection switch KX1 is connected to a first electrode of the first output switch KO1, a control electrode of the first output control switch KS1 is configured to receive a first output control signal, a first electrode of the first output control switch KS1 is connected to a second power supply end VDDH, a second electrode of the first output control switch KS1 is connected to a first electrode of the second selection switch KX2, a second electrode of the second selection switch KX2 is connected to a first electrode of the second output switch KO2, a second electrode of the first output switch KO1 and a second electrode of the second output switch KO2 are both connected to a first signal output end VOUT1, a control electrode of the second input switch KN2 is connected to a second signal input end VIN2, a first electrode of the second input switch KN2 is connected to the first power supply end VSS, a second electrode of the second input switch KN2 is connected to a first electrode of the third selection switch KX3, a second electrode of the third selection switch KX3 is connected to a first electrode of the third output switch KO3, a control electrode of the second output control switch KS2 is configured to receive a second output control signal, a first electrode of the second output control switch KS2 is connected to the second power supply end VDDH, a second electrode of the second output control switch KS2 is connected to a first electrode of the fourth selection switch KX4, a second electrode of the fourth selection switch KX4 is connected to a first electrode of the fourth output switch KO4, a second electrode of the third output switch KO3 and a second electrode of the fourth output switch KO4 are both connected to a second signal output end VOUT2, and a control electrode of the first selection switch KX1, a control electrode of the second selection switch KX2, a control electrode of the third selection switch KX3, and a control electrode of the fourth selection switch KX4 are all connected to a selection control end XC.

In this way, when a power supply voltage input to the second power supply end VDDH exceeds an upper limit of a withstand voltage range of a single switch in the input/output circuit 10, the first signal output end VOUT1 is pulled down through the first input switch KN1, the first selection switch KX1, and the first output switch KO1, to ensure that the first input switch KN1, the first selection switch KX1, and the first output switch KO1 do not experience reliability degradation or failure.

In addition, when the power supply voltage input to the second power supply end VDDH exceeds the upper limit of the withstand voltage range of the single switch in the input/output circuit 10, the first signal output end VOUT1 is pulled up through the first output control switch KS1, the second selection switch KX2, and the second output switch KO2, to ensure that the first output control switch KS1, the second selection switch KX2, and the second output switch KO2 do not experience reliability degradation or failure.

In addition, when the power supply voltage input to the second power supply end VDDH exceeds the upper limit of the withstand voltage range of the single switch in the input/output circuit 10, the second signal output end VOUT2 is pulled down through the second input switch KN2, the third selection switch KX3, and the third output switch KO3, to ensure that the second input switch KN2, the third selection switch KX3, and the third output switch KO3 do not experience reliability degradation or failure.

In addition, when the power supply voltage input to the second power supply end VDDH exceeds the upper limit of the withstand voltage range of the single switch in the input/output circuit 10, the second signal output end VOUT2 is pulled up through the second output control switch KS2, the fourth selection switch KX4, and the fourth output switch KO4, to ensure that the second output control switch KS2, the fourth selection switch KX4, and the fourth output switch KO4 do not experience reliability degradation or failure.

During specific implementation, a voltage at the second power supply end VDDH is greater than a voltage at the first power supply end VSS. Based on this, when the voltage at the second power supply end VDDH is input to the first signal output end VOUT1, a voltage at the first signal output end VOUT1 may be pulled up. When the voltage at the first power supply end VSS is input to the first signal output end VOUT1, the voltage at the first signal output end VOUT1 may be pulled down. Similarly, when the voltage at the second power supply end VDDH is input to the second signal output end VOUT2, a voltage at the second signal output end VOUT2 may be pulled up. When the voltage at the first power supply end VSS is input to the second signal output end VOUT2, the voltage at the second signal output end VOUT2 may be pulled down.

The level shifting circuit 212 in this embodiment of this application may be applied to a scenario in which level shifting is performed on a differential signal. Based on this, signals input to the first signal input end VIN1 and the second signal input end VIN2 may be differential signals, so that signals output from the first signal output end VOUT1 and the second signal output end VOUT2 are also differential signals. Further, the first signal input end VIN1 and the second signal input end VIN2 may be respectively connected to different ports, and the ports may be output ends of the input end circuit 211. In addition, the first signal output end VOUT1 and the second signal output end VOUT2 may also be connected to different ports, and the ports may be input ends of the output end circuit 213.

In this embodiment of this application, the first output control signal and the second output control signal may be respectively input through two different ports, or the first output control signal and the second output control signal may be input through a same port. Further, to reduce a quantity of external ports connected to the level shifting circuit 212 and reduce routing difficulty, as shown in FIG. 3, the control electrode of the first output control switch KS1 may be connected to the control electrode of the third output switch KO3, so that a signal of the control electrode of the third output switch KO3 is used as the first output control signal, to control the first output control switch KS 1 to be turned on or turned off. In addition, the control electrode of the second output control switch KS2 is connected to the control electrode of the first output switch KO1, so that a signal of the control electrode of the first output switch KO1 is used as the second output control signal, to control the second output control switch KS2 to be turned on or turned off. In this way, the control electrode of the first output control switch KS1 and the control electrode of the second output control switch KS2 do not need to be additionally connected to an external port.

For example, as shown in FIG. 3, the first input switch KN1, the second input switch KN2, the first output switch KO1, the third output switch KO3, the first selection switch KX1, and the third selection switch KX3 may all be set as N-type switching transistors, and the first output control switch KS1, the second output control switch KS2, the second output switch KO2, the fourth output switch KO4, the second selection switch KX2, and the fourth selection switch KX4 may all be set as P-type switching transistors. Certainly, during actual application, alternatively, the first input switch KN1, the second input switch KN2, the first output switch KO1, the third output switch KO3, the first selection switch KX1, and the third selection switch KX3 may all be set as P-type switching transistors, and the first output control switch KS1, the second output control switch KS2, the second output switch KO2, the fourth output switch KO4, the second selection switch KX2, and the fourth selection switch KX4 may all be set as N-type switching transistors.

Still as shown in FIG. 3, for the withstand voltage control circuit 20, a first input end is connected to a first withstand voltage control end NC1, a second input end is connected to the first signal output end VOUT1, a third input end is connected to the second signal output end VOUT2, a first output end is connected to a control electrode of the first output switch KO1, a second output end is connected to a control electrode of the second output switch KO2, a third output end is connected to a control electrode of the third output switch KO3, and a fourth output end is connected to a control electrode of the fourth output switch KO4. In this way, the withstand voltage control circuit 20 is disposed, so that when the power supply voltage input to the second power supply end VDDH exceeds the upper limit of the withstand voltage range of the single switch in the input/output circuit 10, the withstand voltage control circuit 20 may adjust voltages of the control electrodes of the first output switch KO1, the second output switch KO2, the third output switch KO3, and the fourth output switch KO4. In this way, a voltage difference between the control electrode and the second electrode of each of the first output switch KO1, the second output switch KO2, the third output switch KO3, and the fourth output switch KO4 is less than or equal to an upper limit of a withstand voltage range of the output switch, to ensure that the first output switch KO1, the second output switch KO2, the third output switch KO3, and the fourth output switch KO4 do not experience reliability degradation or failure.

Specifically, the withstand voltage control circuit 20 may output a voltage at the first withstand voltage control end NC1 or the first signal output end VOUT1 to the control electrode of the first output switch KO1, to adjust the voltage of the control electrode of the first output switch KO1 based on the voltage at the first withstand voltage control end NC1 or the first signal output end VOUT1. In this way, a voltage difference between the control electrode of the first output switch KO1 and the first signal output end VOUT1 is less than or equal to an upper limit of a withstand voltage range of the first output switch KO1, to avoid reliability degradation or failure of the first output switch KO1.

The withstand voltage control circuit 20 may further output a voltage at the first withstand voltage control end NC1 or the first signal output end VOUT1 to the control electrode of the second output switch KO2, to adjust the voltage of the control electrode of the second output switch KO2 based on the voltage at the first withstand voltage control end NC1 or the first signal output end VOUT1. In this way, a voltage difference between the control electrode of the second output switch KO2 and the first signal output end VOUT1 is less than or equal to an upper limit of a withstand voltage range of the second output switch KO2, to avoid reliability degradation or failure of the second output switch KO2.

The withstand voltage control circuit 20 may further output a voltage at the first withstand voltage control end NC1 or the second signal output end VOUT2 to the control electrode of the third output switch KO3, to adjust the voltage of the control electrode of the third output switch KO3 based on the voltage at the first withstand voltage control end NC1 or the second signal output end VOUT2. In this way, a voltage difference between the control electrode of the third output switch KO3 and the second signal output end VOUT2 is less than or equal to an upper limit of a withstand voltage range of the third output switch KO3, to avoid reliability degradation or failure of the third output switch KO3.

The withstand voltage control circuit 20 may further output a voltage at the first withstand voltage control end NC1 or the second signal output end VOUT2 to the control electrode of the fourth output switch KO4, to adjust the voltage of the control electrode of the fourth output switch KO4 based on the voltage at the first withstand voltage control end NC1 or the second signal output end VOUT2. In this way, a voltage difference between the control electrode of the fourth output switch KO4 and the second signal output end VOUT2 is less than or equal to an upper limit of a withstand voltage range of the fourth output switch KO4, to avoid reliability degradation or failure of the fourth output switch KO4.

It may be understood that the voltage at the first withstand voltage control end NC1 is less than or equal to the upper limit of the withstand voltage range of the single switch in the input/output circuit 10. A voltage at the selection control end XC is less than or equal to the upper limit of the withstand voltage range of the single switch in the input/output circuit 10.

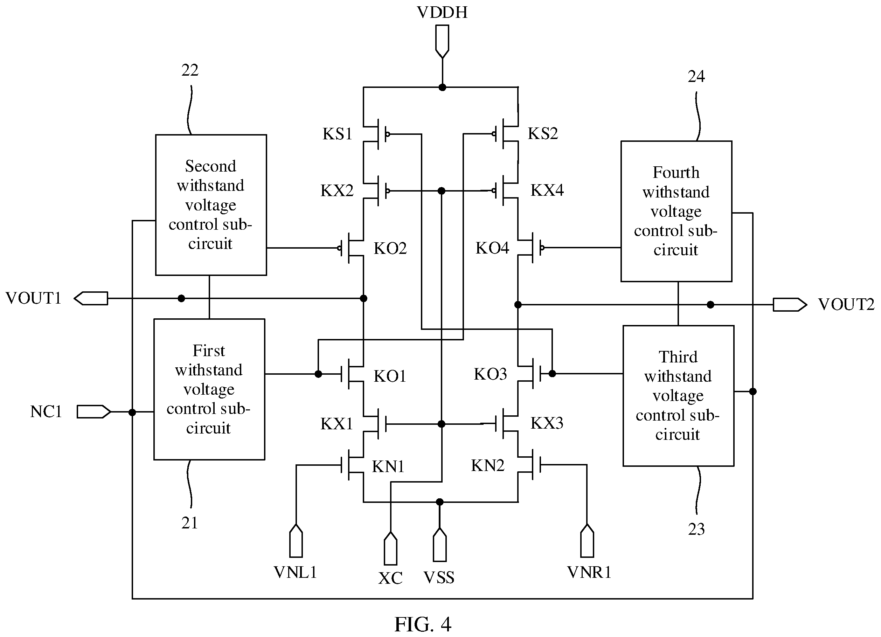

FIG. 4 is a schematic of another circuit structure of the level shifting circuit according to an embodiment of this application. As shown in FIG. 4, a withstand voltage control circuit 20 may include a first withstand voltage control sub-circuit 21, a second withstand voltage control sub-circuit 22, a third withstand voltage control sub-circuit 23, and a fourth withstand voltage control sub-circuit 24. The first withstand voltage control sub-circuit 21, the second withstand voltage control sub-circuit 22, the third withstand voltage control sub-circuit 23, and the fourth withstand voltage control sub-circuit 24 are used to avoid reliability degradation or failure of a switch.

For the first withstand voltage control sub-circuit 21, a first input end is connected to a first withstand voltage control end NC1, a second input end is connected to a first signal output end VOUT1, and an output end is connected to a control electrode of a first output switch KO1. In addition, the first withstand voltage control sub-circuit 21 is configured to output a voltage at the first withstand voltage control end NC1 or the first signal output end VOUT1 to the control electrode of the first output switch KO1 in response to voltages at the first withstand voltage control end NC1 and the first signal output end VOUT1. In this way, the first withstand voltage control sub-circuit 21 may input the voltage at the first withstand voltage control end NC1 or the first signal output end VOUT1 to the control electrode of the first output switch KO1 under control of the voltage at one or both of the first withstand voltage control end NC1 and the first signal output end VOUT1, to adjust the voltage of the control electrode of the first output switch KO1. In this way, a voltage difference between the control electrode of the first output switch KO1 and the first signal output end VOUT1 may be less than or equal to an upper limit of a withstand voltage range of the first output switch KO1, to avoid reliability degradation or failure of the first output switch KO1.

For the second withstand voltage control sub-circuit 22, a first input end is connected to a first withstand voltage control end NC1, a second input end is connected to a first signal output end VOUT1, and an output end is connected to a control electrode of a second output switch KO2. In addition, the second withstand voltage control sub-circuit 22 is configured to output a voltage at the first withstand voltage control end NC1 or the first signal output end VOUT1 to the control electrode of the second output switch KO2 in response to voltages at the first withstand voltage control end NC1 and the first signal output end VOUT1. In this way, the second withstand voltage control sub-circuit 22 may input the voltage at the first withstand voltage control end NC1 or the first signal output end VOUT1 to the voltage of the control electrode of the second output switch KO2 under control of the voltage at one or both of the first withstand voltage control end NC1 and the first signal output end VOUT1, to adjust the voltage of the control electrode of the second output switch KO2. In this way, a voltage difference between the control electrode of the second output switch KO2 and the first signal output end VOUT1 is less than or equal to an upper limit of a withstand voltage range of the second output switch KO2, to avoid reliability degradation or failure of the second output switch KO2.

For the third withstand voltage control sub-circuit 23, a first input end is connected to the first withstand voltage control end NC1, a second input end is connected to a second signal output end VOUT2, and an output end is connected to a control electrode of a third output switch KO3; and the third withstand voltage control sub-circuit 23 is configured to output a voltage at the first withstand voltage control end NC1 or the second signal output end VOUT2 to the control electrode of the third output switch KO3 in response to voltages at the first withstand voltage control end NC1 and the second signal output end VOUT2. In this way, the third withstand voltage control sub-circuit 23 may input the voltage at the first withstand voltage control end NC1 or the second signal output end VOUT2 to the control electrode of the third output switch KO3 under control of the voltage at one or both of the first withstand voltage control end NC1 and the second signal output end VOUT2, to adjust the voltage of the control electrode of the third output switch KO3. In this way, a voltage difference between the control electrode of the third output switch KO3 and the second signal output end VOUT2 is less than or equal to an upper limit of a withstand voltage range of the third output switch KO3, to avoid reliability degradation or failure of the third output switch KO3.

For the fourth withstand voltage control sub-circuit 24, a first input end is connected to the first withstand voltage control end NC1, a second input end is connected to a second signal output end VOUT2, and an output end is connected to a control electrode of a fourth output switch KO4; and the fourth withstand voltage control sub-circuit 24 is configured to output a voltage at the first withstand voltage control end NC1 or the second signal output end VOUT2 to the control electrode of the fourth output switch KO4 in response to voltages at the first withstand voltage control end NC1 and the second signal output end VOUT2. In this way, the fourth withstand voltage control sub-circuit 24 may input the voltage at the first withstand voltage control end NC1 or the second signal output end VOUT2 to the control electrode of the fourth output switch KO4 under control of the voltage at one or both of the first withstand voltage control end NC1 and the second signal output end VOUT2, to adjust the voltage of the control electrode of the fourth output switch KO4. In this way, a voltage difference between the control electrode of the fourth output switch KO4 and the second signal output end VOUT2 is less than or equal to an upper limit of a withstand voltage range of the fourth output switch KO4, to avoid reliability degradation or failure of the fourth output switch KO4.

In this embodiment of this application, the withstand voltage control sub-circuit may be formed by using switches.

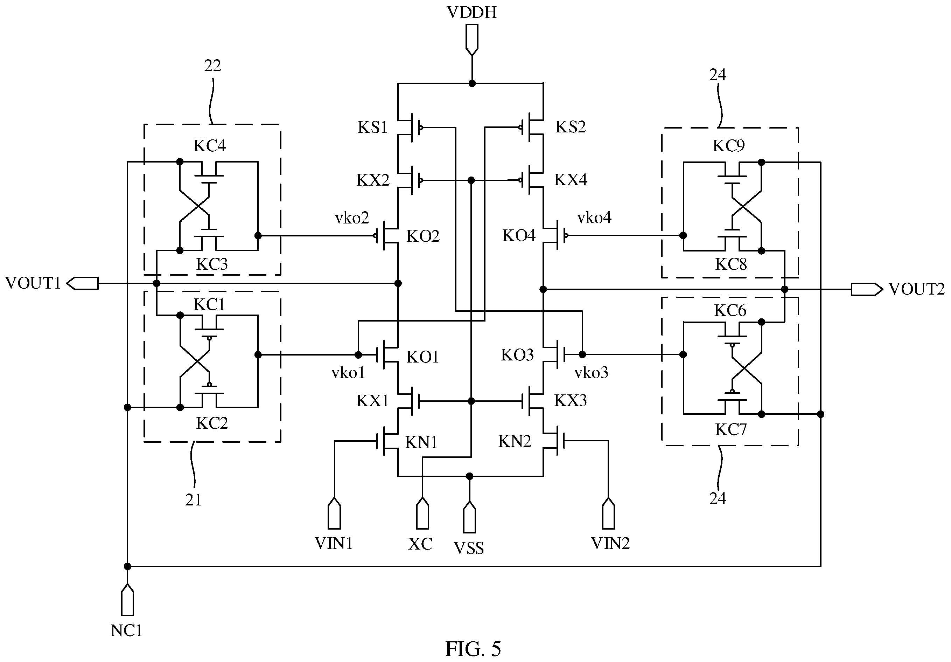

FIG. 5 is a schematic of a specific circuit structure of the level shifting circuit according to an embodiment of this application. As shown in FIG. 5, a first withstand voltage control sub-circuit 21 may include a first control switch KC1 and a second control switch KC2. A control electrode of the first control switch KC1 is connected to a first withstand voltage control end NC1, a first electrode of the first control switch KC1 is connected to a first signal output end VOUT1, and a second electrode of the first control switch KC1 is connected to a control electrode of a first output switch KO1. In addition, a control electrode of the second control switch KC2 is connected to the first signal output end VOUT1, a first electrode of the second control switch KC2 is connected to the first withstand voltage control end NC1, and a second electrode of the second control switch KC2 is connected to the control electrode of the first output switch KO1. In this way, a first withstand voltage control sub-circuit 21 with a simple structure can be implemented, so that application is simple, and production costs can be further reduced. For example, the first control switch KC1 and the second control switch KC2 may be set as P-type switching transistors. Certainly, during actual application, the first control switch KC1 and the second control switch KC2 may alternatively be set as N-type switching transistors.

The second withstand voltage control sub-circuit 22 may include a third control switch KC3 and a fourth control switch KC4. A control electrode of the third control switch KC3 is connected to the first withstand voltage control end NC1, a first electrode of the third control switch KC3 is connected to the first signal output end VOUT1, and a second electrode of the third control switch KC3 is connected to a control electrode of a second output switch KO2. In addition, a control electrode of the fourth control switch KC4 is connected to the first signal output end VOUT1, a first electrode of the fourth control switch KC4 is connected to the first withstand voltage control end NC1, and a second electrode of the fourth control switch KC4 is connected to the control electrode of the second output switch KO2. In this way, a second withstand voltage control sub-circuit 22 with a simple structure can be implemented, so that application is simple, and production costs can be further reduced. For example, the third control switch KC3 and the fourth control switch KC4 may be set as N-type switching transistors. Certainly, during actual application, the third control switch KC3 and the fourth control switch KC4 may alternatively be set as P-type switching transistors.

The third withstand voltage control sub-circuit 23 may include a sixth control switch KC6 and a seventh control switch KC7. A control electrode of the sixth control switch KC6 is connected to the first withstand voltage control end NC1, a first electrode of the sixth control switch KC6 is connected to the second signal output end VOUT2, and a second electrode of the sixth control switch KC6 is connected to a control electrode of a third output switch KO3. In addition, a control electrode of the seventh control switch KC7 is connected to the second signal output end VOUT2, a first electrode of the seventh control switch KC7 is connected to the first withstand voltage control end NC1, and a second electrode of the seventh control switch KC7 is connected to the control electrode of the third output switch KO3. In this way, a third withstand voltage control sub-circuit 23 with a simple structure can be implemented, so that application is simple, and production costs can be further reduced. For example, the sixth control switch KC6 and the seventh control switch KC7 may be set as P-type switching transistors. Certainly, during actual application, the sixth control switch KC6 and the seventh control switch KC7 may alternatively be set as N-type switching transistors.

The fourth withstand voltage control sub-circuit 24 may include an eighth control switch KC8 and a ninth control switch KC9. A control electrode of the eighth control switch KC8 is connected to the first withstand voltage control end NC1, a first electrode of the eighth control switch KC8 is connected to the second signal output end VOUT2, and a second electrode of the eighth control switch KC8 is connected to a control electrode of a fourth output switch KO4. In addition, a control electrode of the ninth control switch KC9 is connected to the second signal output end VOUT2, a first electrode of the ninth control switch KC9 is connected to the first withstand voltage control end NC1, and a second electrode of the ninth control switch KC9 is connected to the control electrode of the fourth output switch KO4. In this way, a fourth withstand voltage control sub-circuit 24 with a simple structure can be implemented, so that application is simple, and production costs can be further reduced. In this way, a function of the fourth withstand voltage control sub-circuit 24 can be implemented. For example, the eighth control switch KC8 and the ninth control switch KC9 may be set as N-type switching transistors. Certainly, during actual application, the eighth control switch KC8 and the ninth control switch KC9 may alternatively be set as P-type switching transistors.

It may be understood that the foregoing is merely examples of a specific structure of the withstand voltage control circuit 20 provided in embodiments of this application. During specific implementation, the specific structure of the withstand voltage control circuit 20 is not limited to the foregoing structures provided in embodiments of this application, and may be another structure known by a person skilled in the art. This is not limited herein.

In the level shifting circuit 212 in this application, when the voltage at the second power supply end VDDH is higher than the upper limit of the withstand voltage range of the single switch in the input/output circuit 10, reliability degradation or failure of each output switch can be avoided. Based on this, the voltage Vddl of the first withstand voltage control end NC1 can meet the following relationship: Vddh-Vddl≤Vmax, where Vmax represents the upper limit of the withstand voltage range of the single switch.

The following uses the structure shown in FIG. 5 as an example. With reference to a signal time sequence diagram, when the voltage at the second power supply end VDDH is higher than the upper limit of the withstand voltage range of the single switch in the input/output circuit 10, an operating process of the level shifting circuit 212 provided in this embodiment of this application is specifically described.

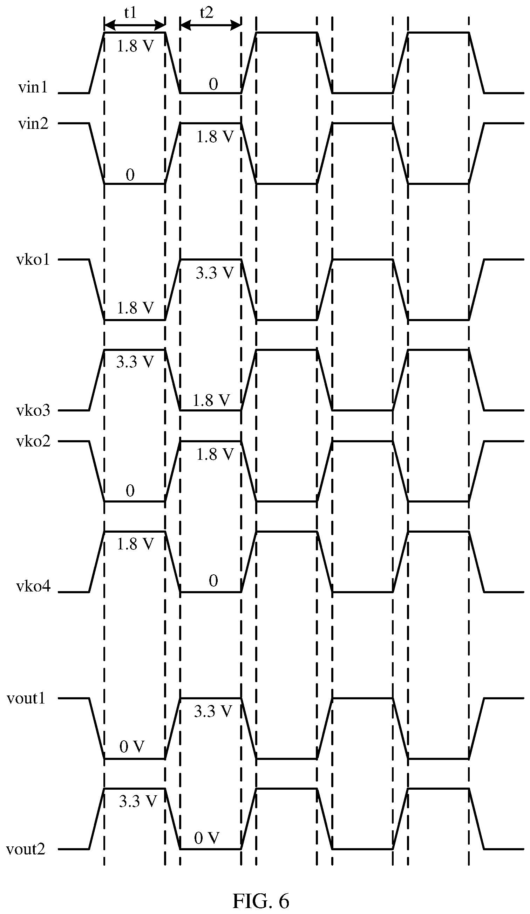

FIG. 6 is a signal time sequence diagram according to an embodiment of this application. As shown in FIG. 6, for example, a voltage at the second power supply end VDDH is 3.3 V, a voltage at the first power supply end VSS is 0 V, the upper limit of the withstand voltage range of the single switch is 1.8 V, a voltage at the first withstand voltage control end NC1 is 1.8 V or half of 3.3 V, a voltage at the selection control end XC is 1.8 V, and voltages of signals input to the first signal input end VIN1 and the second signal input end VIN2 alternately change between 0 V and 1.8 V. Herein, vin1 represents a signal of the first signal input end VIN1, vin2 represents a signal of the second signal input end VIN2, vko1 represents a signal of the control electrode of the first output switch KO1, vko2 represents a signal of the control electrode of the second output switch KO2, vko3 represents a signal of the control electrode of the third output switch KO3, vko4 represents a signal of the control electrode of the fourth output switch KO4, vout1 represents a signal of the first signal output end VOUT1, vout2 represents a signal of the second signal output end VOUT2, and xc represents a signal of the selection control end XC.

In a t1 phase, the first input switch KN1, the first output switch KO1, the second output switch KO2, the second output control switch KS2, the third output switch KO3, the fourth output switch KO4, the second control switch KC2, the third control switch KC3, the sixth control switch KC6, and the ninth control switch KC9 are all turned on, while the second input switch KN2, the first output control switch KS1, the first control switch KC1, the fourth control switch KC4, the seventh control switch KC7, and the eighth control switch KC8 are all turned off. In this case, the voltage at the first power supply end VSS is input to the first signal output end VOUT1 through the first input switch KN1, the first selection switch KX1, and the first output switch KO1, to pull down the first signal output end VOUT1 to 0 V, so as to ensure that the first input switch KN1, the first selection switch KX1, and the first output switch KO1 do not experience reliability degradation or failure. The voltage at the second power supply end VDDH is input to the second signal output end VOUT2 through the first output control switch KS1, the second selection switch KX2, and the second output switch KO2, to pull up the second signal output end VOUT2 to 3.3 V, so as to ensure that the first output control switch KS1, the second selection switch KX2, and the second output switch KO2 do not experience reliability degradation or failure. In addition, the voltage at the first withstand voltage control end NC1 is separately input to the control electrode of the first output switch KO1 and the control electrode of the fourth output switch KO4, so that a voltage of the control electrode of the first output switch KO1 and a voltage of the control electrode of the fourth output switch KO4 are both 1.8 V. The first control switch KC1 and the second control switch KC2 form a self-protection circuit, so that a voltage difference between the control electrode of the first output switch KO1 and the first signal output end VOUT1 is 1.8 V, which meets a withstand voltage range of the first output switch KO1. The eighth control switch KC8 and the ninth control switch KC9 form a self-protection circuit, so that a voltage difference between the control electrode of the fourth output switch KO4 and the second signal output end VOUT2 is 1.5 V, which meets a withstand voltage range of the fourth output switch KO4 likewise. In addition, the third control switch KC3 and the fourth control switch KC4 form a self-protection circuit, so that the voltage at the first signal output end VOUT1 can be input to the control electrode of the second output switch KO2, and a voltage difference between the control electrode of the second output switch KO2 and the first signal output end VOUT1 is 0 V, which meets a withstand voltage range of the second output switch KO2. The sixth control switch KC6 and the seventh control switch KC7 form a self-protection circuit, so that a voltage at the second signal output end VOUT2 can be input to the control electrode of the third output switch KO3, and a voltage difference between the control electrode of the third output switch KO3 and the second signal output end VOUT2 is 0 V, which meets a withstand voltage range of the third output switch KO3. In this way, it can be ensured that the first output switch KO1 to the fourth output switch KO4 respectively meet the withstand voltage ranges of the first output switch KO1 to the fourth output switch KO4, and reliability degradation or failure of the first output switch KO1 to the fourth output switch KO4 can be avoided.

In a t2 phase, the second input switch KN2, the first output switch KO1, the second output switch KO2, the first output control switch KS1, the third output switch KO3, the fourth output switch KO4, the first control switch KC1, the fourth control switch KC4, the seventh control switch KC7, and the eighth control switch KC8 are all turned on, while the first input switch KN1, the second output control switch KS2, the second control switch KC2, the third control switch KC3, the sixth control switch KC6, and the ninth control switch KC9 are all turned off. In this case, the voltage at the first power supply end VSS is input to the second signal output end VOUT2 through the second input switch KN2, the third selection switch KX3, and the third output switch KO3, to pull down the second signal output end VOUT2 to 0 V, so as to ensure that the second input switch KN2, the third selection switch KX3, and the third output switch KO3 do not experience reliability degradation or failure. The voltage at the second power supply end VDDH is input to the first signal output end VOUT1 through the second output control switch KS2, the fourth selection switch KX4, and the fourth output switch KO4, to pull up the first signal output end VOUT1 to 3.3 V, so as to ensure that the second output control switch KS2, the fourth selection switch KX4, and the fourth output switch KO4 do not experience reliability degradation or failure. In addition, the voltage at the first withstand voltage control end NC1 is separately input to the control electrode of the second output switch KO2 and the control electrode of the third output switch KO3, so that a voltage of the control electrode of the second output switch KO2 and a voltage of the control electrode of the third output switch KO3 are both 1.8 V. The third control switch KC3 and the fourth control switch KC4 form a self-protection circuit, so that a voltage difference between the control electrode of the second output switch KO2 and the first signal output end VOUT1 is 1.5 V, which meets the withstand voltage range of the second output switch KO2. The sixth control switch KC6 and the seventh control switch KC7 form a self-protection circuit, so that a voltage difference between the control electrode of the third output switch KO3 and the second signal output end VOUT2 is 1.8 V, which meets the withstand voltage range of the third output switch KO3 likewise. In addition, the first control switch KC1 and the second control switch KC2 form a self-protection circuit, so that the voltage at the first signal output end VOUT1 can be input to the control electrode of the first output switch KO1, and a voltage difference between the control electrode of the first output switch KO1 and the first signal output end VOUT1 is 0 V, which meets the withstand voltage range of the first output switch KO1. The eighth control switch KC8 and the ninth control switch KC9 form a self-protection circuit, so that a voltage at the second signal output end VOUT2 can be input to the control electrode of the fourth output switch KO4, and a voltage difference between the control electrode of the fourth output switch KO4 and the second signal output end VOUT2 is 0 V, which meets the withstand voltage range of the fourth output switch KO4. In this way, it can be ensured that the first output switch KO1 to the fourth output switch KO4 respectively meet the withstand voltage ranges of the first output switch KO1 to the fourth output switch KO4, and reliability degradation or failure of the first output switch KO1 to the fourth output switch KO4 can be avoided.

Then, an operating process of the level shifting circuit 212 may be repeating operations in the t1 phase and the t2 phase. Details are not described herein.

It can be learned from the foregoing embodiments that, when the voltage input to the second power supply end VDDH is greater than the upper limit of the withstand voltage range of the single switch, the switches in the withstand voltage control circuit 20 may operate, so that each output switch operates in the withstand voltage range. Therefore, the level shifting circuit 212 in this embodiment of this application is applicable to an application scenario in which the voltage input to the second power supply end VDDH is greater than the upper limit of the withstand voltage range of the single switch.

In some other application scenarios, in a period of time, if the voltage input to the second power supply end VDDH is greater than the upper limit of the withstand voltage range of the single switch, for example, the voltage input to the second power supply end VDDH is 3.3 V, the level shifting circuit 212 needs to be applied to a 3.3 V scenario. In another period of time, if the voltage input to the second power supply end VDDH is less than the upper limit of the withstand voltage range of the single switch, for example, the voltage input to the second power supply end VDDH is reduced to 1.8 V, the level shifting circuit 212 needs to be applied to a 1.8 V scenario. In the conventional technology, to meet requirements of the two scenarios, two different level shifting circuits 212 are usually disposed. Consequently, the level shifting circuits 212 occupy a large area of a chip, resulting in a cost increase. Therefore, an embodiment of this application provides another level shifting circuit 212. Through switching control, the level shifting circuit 212 can be switched between the 3.3 V scenario and the 1.8 V scenario, so that no other level shifting circuit 212 needs to be additionally disposed, thereby reducing occupation of the area of the chip by the level shifting circuit 212, and reducing costs.

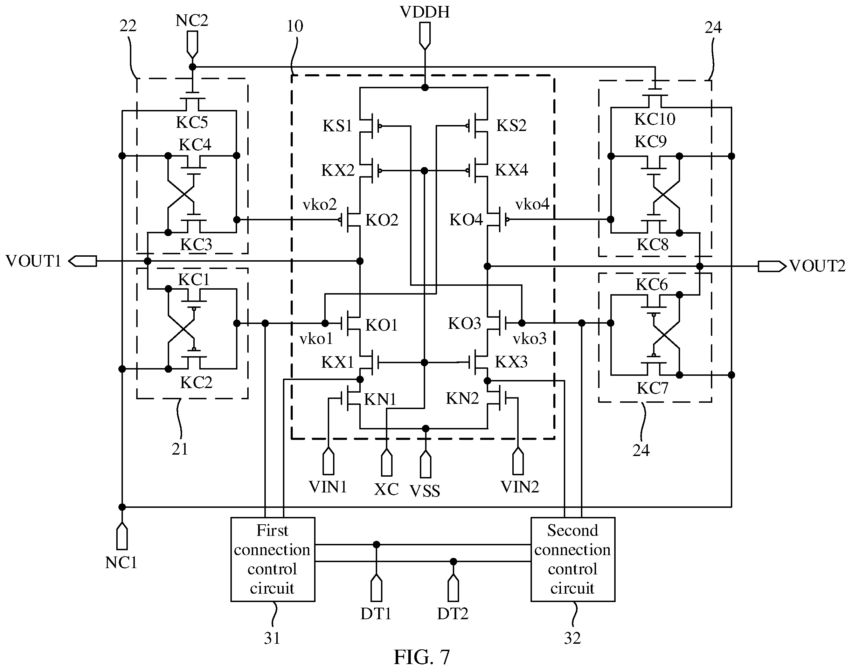

FIG. 7 is a schematic of another circuit structure of a level shifting circuit according to an embodiment of this application. As shown in FIG. 7, a withstand voltage control circuit 20 may include a first withstand voltage control sub-circuit 21, a second withstand voltage control sub-circuit 22, a third withstand voltage control sub-circuit 23, and a fourth withstand voltage control sub-circuit 24. In addition, for specific structures of the first withstand voltage control sub-circuit 21, the second withstand voltage control sub-circuit 22, the third withstand voltage control sub-circuit 23, and the fourth withstand voltage control sub-circuit 24, refer to the content in the foregoing embodiments. Details are not described herein.

In addition, the second withstand voltage control sub-circuit 22 includes not only a third control switch KC3 and a fourth control switch KC4, but also a fifth control switch KC5. A control electrode of the fifth control switch KC5 is connected to a second withstand voltage control end NC2, a first electrode of the fifth control switch KC5 is connected to a first withstand voltage control end NC1, and a second electrode of the fifth control switch KC5 is connected to a control electrode of a second output switch KO2. For example, the fifth control switch KC5 may be set to an N-type switching transistor. Certainly, during actual application, the fifth control switch KC5 may alternatively be set as a P-type switching transistor.

In addition, the fourth withstand voltage control sub-circuit 24 includes not only an eighth control switch KC8 and a ninth control switch KC9, but also a tenth control switch KC10. A control electrode of the tenth control switch KC10 is connected to the second withstand voltage control end NC2, a first electrode of the tenth control switch KC10 is connected to the first withstand voltage control end NC1, and a second electrode of the tenth control switch KC10 is connected to a control electrode of a fourth output switch KO4. For example, the tenth control switch KC10 may be set to an N-type switching transistor. Certainly, during actual application, the tenth control switch KC10 may alternatively be set as a P-type switching transistor.

As shown in FIG. 7, the level shifting circuit 212 may further include a first connection control circuit 31 and a second connection control circuit 32. An input end of the first connection control circuit 31 is connected to a second electrode of a first input switch KN1, an output end of the first connection control circuit 31 is connected to a control electrode of a first output switch KO1, and the first connection control circuit 31 is configured to control connection or disconnection between the second electrode of the first input switch KN1 and the control electrode of the first output switch KO1. In addition, an input end of the second connection control circuit 32 is connected to a second electrode of a second input switch KN2, an output end of the second connection control circuit 32 is connected to a control electrode of a third output switch KO3, and the second connection control circuit 32 is configured to control connection or disconnection between the second electrode of the second input switch KN2 and the control electrode of the third output switch KO3. During operation, if a voltage input to a second power supply end VDDH is greater than an upper limit of a withstand voltage range of a single switch, for example, the voltage input to the second power supply end VDDH is 3.3 V, the first connection control circuit 31 is controlled to disconnect the second electrode of the first input switch KN1 from the control electrode of the first output switch KO1, and the second connection control circuit 32 is controlled to disconnect the second electrode of the second input switch KN2 from the control electrode of the third output switch KO3. If the voltage input to the second power supply end VDDH is less than the upper limit of the withstand voltage range of the single switch, for example, the voltage input to the second power supply end VDDH is reduced to 1.8 V, the first connection control circuit 31 is controlled to connect the second electrode of the first input switch KN1 to the control electrode of the first output switch KO1, and the second connection control circuit 32 is controlled to connect the second electrode of the second input switch KN2 to the control electrode of the third output switch KO3.

In this embodiment of this application, the first connection control circuit 31 and the second connection control circuit 32 may be formed by using switches.

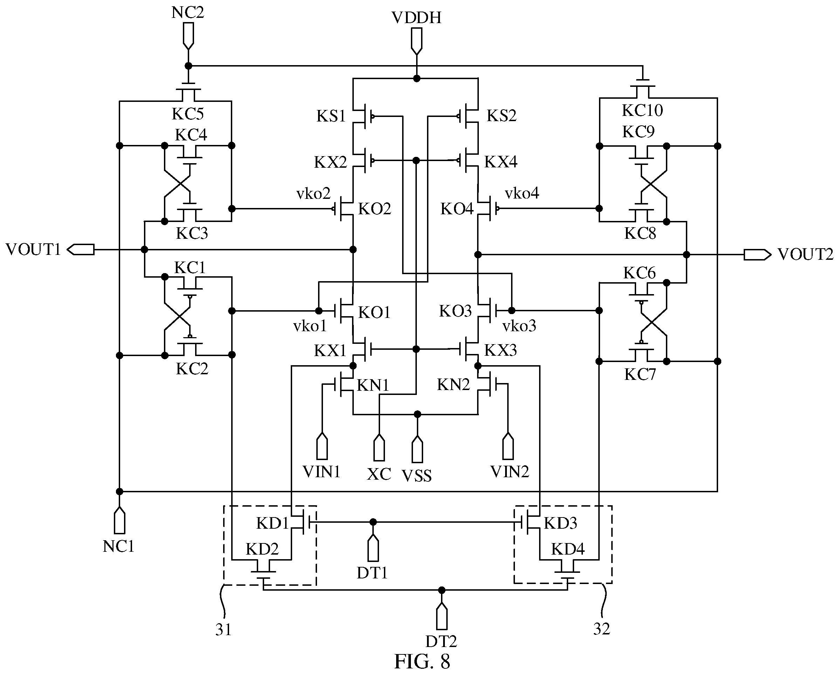

FIG. 8 is a schematic of another specific circuit structure of the level shifting circuit according to an embodiment of this application. As shown in FIG. 8, the first connection control circuit 31 may include a first connection control switch KD1 and a second connection control switch KD2. A control electrode of the first connection control switch KD1 is connected to a first connection control end DT1, a first electrode of the first connection control switch KD1 is connected to the second electrode of the first input switch KN1, and a second electrode of the first connection control switch KD 1 is connected to a first electrode of the second connection control switch KD2. In addition, a control electrode of the second connection control switch KD2 is connected to a second connection control end DT2, and a second electrode of the second connection control switch KD2 is connected to the control electrode of the first output switch KO1. In this way, a first connection control circuit 31 with a simple structure can be implemented, so that application is simple, and production costs can be further reduced. For example, the first connection control switch KD1 and the second connection control switch KD2 may be set as N-type switching transistors. Certainly, during actual application, the first connection control switch KD1 and the second connection control switch KD2 may alternatively be set as P-type switching transistors.

The second connection control circuit 32 may include a third connection control switch KD3 and a fourth connection control switch KD4. A control electrode of the third connection control switch KD3 is connected to the first connection control end DT1, a first electrode of the third connection control switch KD3 is connected to the second electrode of the second input switch KN2, and a second electrode of the third connection control switch KD3 is connected to a first electrode of the fourth connection control switch KD4. In addition, a control electrode of the fourth connection control switch KD4 is connected to the second connection control end DT2, and a second electrode of the fourth connection control switch KD4 is connected to the control electrode of the third output switch KO3. In this way, a second connection control circuit 32 with a simple structure can be implemented, so that application is simple, and production costs can be further reduced. For example, the third connection control switch KD3 and the fourth connection control switch KD4 may be set as N-type switching transistors. Certainly, during actual application, the third connection control switch KD3 and the fourth connection control switch KD4 may alternatively be set as P-type switching transistors.

In the level shifting circuit 212 in this application, when the voltage at the second power supply end VDDH is higher than the upper limit of the withstand voltage range of the single switch, reliability degradation or failure of each output switch can be avoided. Based on this, a voltage at the second withstand voltage control end NC2 may be set to 0 V, so that a voltage Vddl of the first withstand voltage control end NC1 can meet the following relationship: Vddh-Vddl≤Vmax, where Vmax represents the upper limit of the withstand voltage range of the single switch. When the voltage at the second power supply end VDDH is less than or equal to the upper limit of the withstand voltage range of the single switch, the voltage Vddl of the first withstand voltage control end NC1 may be set to 0 V, and the voltage at the second withstand voltage control end NC2 is set to be less than or equal to the upper limit of the withstand voltage range of the single switch. For example, the voltage at the second withstand voltage control end NC2 is set to 1.8 V.

The following uses the structure shown in FIG. 8 as an example. With reference to a signal time sequence diagram, when the voltage at the second power supply end VDDH is higher than the upper limit of the withstand voltage range of the single switch, an operating process of the level shifting circuit 212 provided in this embodiment of this application is specifically described.

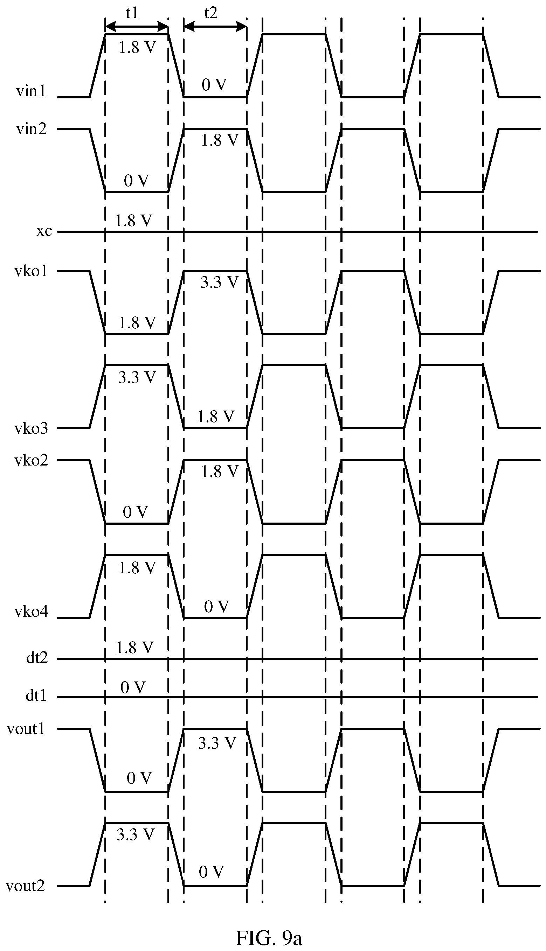

FIG. 9a is another signal time sequence diagram according to an embodiment of this application. As shown in FIG. 9a, for example, a voltage at the second power supply end VDDH is 3.3 V, a voltage at the first power supply end VSS is 0 V, the upper limit of the withstand voltage range of the single switch is 1.8 V, a voltage at the first withstand voltage control end NC1 is 1.8 V or half of 3.3 V, a voltage at the second withstand voltage control end NC2 is 0 V, a voltage at the selection control end XC is 1.8 V, and voltages of signals input to the first signal input end VIN1 and the second signal input end VIN2 alternately change between 0 V and 1.8 V. Herein, vin1 represents a signal of the first signal input end VIN1, vin2 represents a signal of the second signal input end VIN2, vko1 represents a signal of the control electrode of the first output switch KO1, vko2 represents a signal of the control electrode of the second output switch KO2, vko3 represents a signal of the control electrode of the third output switch KO3, vko4 represents a signal of the control electrode of the fourth output switch KO4, vout1 represents a signal of the first signal output end VOUT1, vout2 represents a signal of the second signal output end VOUT2, xc represents a signal of the selection control end XC, da1 represents a signal of the first connection control end DT1, and da2 represents a signal of the second connection control end DT2.

In a t1 phase, the first input switch KN1, the first selection switch KX1, the first output switch KO1, the second output switch KO2, the second selection switch KX2, the second output control switch KS2, the fourth selection switch KX4, the third output switch KO3, the fourth output switch KO4, the third selection switch KX3, the second control switch KC2, the third control switch KC3, the sixth control switch KC6, and the ninth control switch KC9 are all turned on, while the second input switch KN2, the first output control switch KS1, the first control switch KC1, the fourth control switch KC4, the fifth control switch KC5, the seventh control switch KC7, the eighth control switch KC8, and the tenth control switch KC10 are all turned off. In this case, the voltage at the first power supply end VSS is input to the first signal output end VOUT1, to pull down the first signal output end VOUT1 to 0 V, and the voltage at the second power supply end VDDH is input to the second signal output end VOUT2, to pull up the second signal output end VOUT2 to 3.3 V. In addition, the voltage at the first withstand voltage control end NC1 is separately input to the control electrode of the first output switch KO1 and the control electrode of the fourth output switch KO4, so that a voltage of the control electrode of the first output switch KO1 and a voltage of the control electrode of the fourth output switch KO4 are both 1.8 V. The first control switch KC1 and the second control switch KC2 form a self-protection circuit, so that a voltage difference between the control electrode of the first output switch KO1 and the first signal output end VOUT1 is 1.8 V, which meets a withstand voltage range of the first output switch KO1. The eighth control switch KC8, the ninth control switch KC9, and the tenth control switch KC10 form a self-protection circuit, so that a voltage difference between the control electrode of the fourth output switch KO4 and the second signal output end VOUT2 is 1.5 V, which meets a withstand voltage range of the fourth output switch KO4 likewise. In addition, the third control switch KC3, the fourth control switch KC4, and the fifth control switch KC5 form a self-protection circuit, so that the voltage at the first signal output end VOUT1 can be input to the control electrode of the second output switch KO2, and a voltage difference between the control electrode of the second output switch KO2 and the first signal output end VOUT1 is 0 V, which meets a withstand voltage range of the second output switch KO2. The sixth control switch KC6 and the seventh control switch KC7 form a self-protection circuit, so that a voltage at the second signal output end VOUT2 can be input to the control electrode of the third output switch KO3, and a voltage difference between the control electrode of the third output switch KO3 and the second signal output end VOUT2 is 0 V, which meets a withstand voltage range of the third output switch KO3. In this way, it can be ensured that the first output switch KO1 to the fourth output switch KO4 respectively meet the withstand voltage ranges of the first output switch KO1 to the fourth output switch KO4, and reliability degradation or failure of the first output switch KO1 to the fourth output switch KO4 can be avoided. In addition, the first signal output end VOUT1 is pulled down through the first input switch KN1, the first selection switch KX1, and the first output switch KO1, so that a voltage problem of each switch can be overcome. In addition, the second signal output end VOUT2 is pulled up through the second output control switch KS2, the fourth selection switch KX4, and the fourth output switch KO4, so that a withstand voltage problem of each switch can be overcome.

In a t2 phase, the second input switch KN2, the first selection switch KX1, the first output switch KO1, the second output switch KO2, the second selection switch KX2, the first output control switch KS1, the fourth selection switch KX4, the third output switch KO3, the fourth output switch KO4, the third selection switch KX3, the first control switch KC1, the fourth control switch KC4, the seventh control switch KC7, and the eighth control switch KC8 are all turned on, while the first input switch KN1, the second output control switch KS2, the second control switch KC2, the third control switch KC3, the fifth control switch KC5, the sixth control switch KC6, the ninth control switch KC9, and the tenth control switch KC10 are all turned off. In this case, the voltage at the first power supply end VSS is input to the second signal output end VOUT2, to pull down the second signal output end VOUT2 to 0 V, and the voltage at the second power supply end VDDH is input to the first signal output end VOUT1, to pull up the first signal output end VOUT1 to 3.3 V. In addition, the voltage at the first withstand voltage control end NC1 is separately input to the control electrode of the second output switch KO2 and the control electrode of the third output switch KO3, so that a voltage of the control electrode of the second output switch KO2 and a voltage of the control electrode of the third output switch KO3 are both 1.8 V. The third control switch KC3, the fourth control switch KC4, and the fifth control switch KC5 form a self-protection circuit, so that a voltage difference between the control electrode of the second output switch KO2 and the first signal output end VOUT1 is 1.5 V, which meets the withstand voltage range of the second output switch KO2. The sixth control switch KC6 and the seventh control switch KC7 form a self-protection circuit, so that a voltage difference between the control electrode of the third output switch KO3 and the second signal output end VOUT2 is 1.8 V, which meets the withstand voltage range of the third output switch KO3 likewise. In addition, the first control switch KC1 and the second control switch KC2 form a self-protection circuit, so that the voltage at the first signal output end VOUT1 can be input to the control electrode of the first output switch KO1, and a voltage difference between the control electrode of the first output switch KO1 and the first signal output end VOUT1 is 0 V, which meets the withstand voltage range of the first output switch KO1. The eighth control switch KC8, the ninth control switch KC9, and the tenth control switch KC10 form a self-protection circuit, so that a voltage at the second signal output end VOUT2 can be input to the control electrode of the fourth output switch KO4, and a voltage difference between the control electrode of the fourth output switch KO4 and the second signal output end VOUT2 is 0 V, which meets the withstand voltage range of the fourth output switch KO4. In this way, it can be ensured that the first output switch KO1 to the fourth output switch KO4 respectively meet the withstand voltage ranges of the first output switch KO1 to the fourth output switch KO4, and reliability degradation or failure of the first output switch KO1 to the fourth output switch KO4 can be avoided. The first signal output end VOUT1 is pulled up through the first output control switch KS1, the second selection switch KX2, and the second output switch KO2, so that a withstand voltage problem of each switch can be overcome. In addition, the second signal output end VOUT2 is pulled down through the second input switch KN2, the third selection switch KX3, and the third output switch KO3, so that a withstand voltage problem of each switch can be overcome.

Then, an operating process of the level shifting circuit 212 may be repeating operations in the t1 phase and the t2 phase. Details are not described herein. In addition, the second connection control switch KD2 and the fourth connection control switch KD4 may both be turned on, while the first connection control switch KD1 and the third connection control switch KD3 may both be turned off. Alternatively, the first connection control switch KD1, the second connection control switch KD2, the third connection control switch KD3, and the fourth connection control switch KD4 may all be turned off.

It can be learned from the foregoing embodiments that, when the voltage input to the second power supply end VDDH is greater than the upper limit of the withstand voltage range of the single switch, the switches in the withstand voltage control circuit 20 may operate, so that each output switch operates in the withstand voltage range. Therefore, the level shifting circuit 212 in this embodiment of this application is applicable to an application scenario in which the voltage input to the second power supply end VDDH is greater than the upper limit of the withstand voltage range of the single switch.

The following continues to use the structure shown in FIG. 8 as an example. With reference to a signal time sequence diagram, when the voltage at the second power supply end VDDH is less than or equal to the upper limit of the withstand voltage range of the single switch, an operating process of the level shifting circuit 212 provided in this embodiment of this application is specifically described.

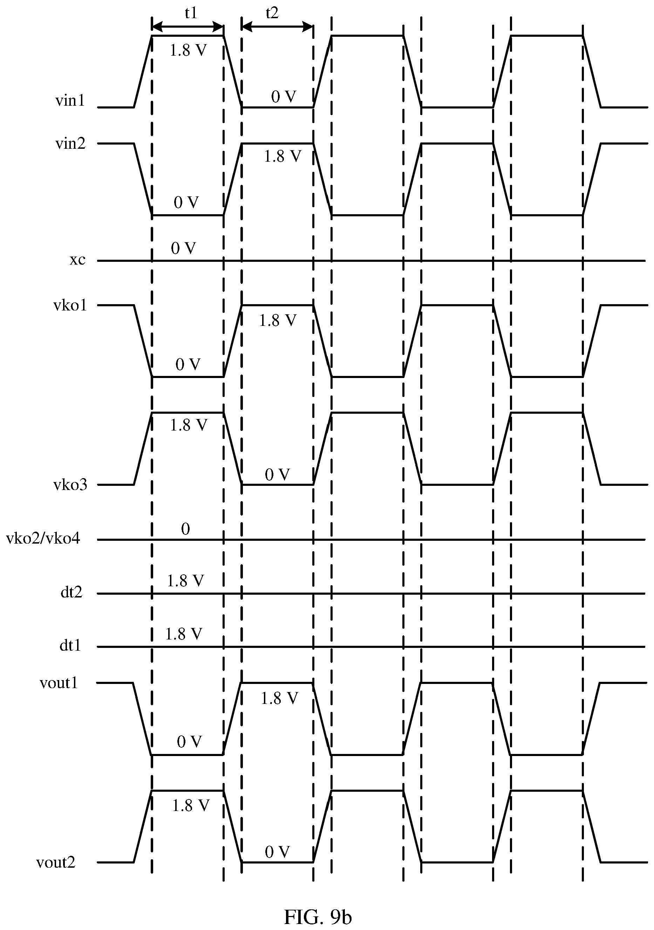

FIG. 9b is another signal time sequence diagram according to an embodiment of this application. As shown in FIG. 9b, for example, a voltage at the second power supply end VDDH is 1.8 V, a voltage at the first power supply end VSS is 0 V, the upper limit of the withstand voltage range of the single switch is 1.8 V, a voltage at the first withstand voltage control end NC1 is 0 V, a voltage at the second withstand voltage control end NC2 is 1.8 V, a voltage at the selection control end XC is 0 V, and voltages of signals input to the first signal input end VIN1 and the second signal input end VIN2 alternately change between 0 V and 1.8 V. Herein, vin1 represents a signal of the first signal input end VIN1, vin2 represents a signal of the second signal input end VIN2, vko1 represents a signal of the control electrode of the first output switch KO1, vko2 represents a signal of the control electrode of the second output switch KO2, vko3 represents a signal of the control electrode of the third output switch KO3, vko4 represents a signal of the control electrode of the fourth output switch KO4, vout1 represents a signal of the first signal output end VOUT1, vout2 represents a signal of the second signal output end VOUT2, xc represents a signal of the selection control end XC, da1 represents a signal of the first connection control end DT1, and da2 represents a signal of the second connection control end DT2.

In a t1 phase, the first input switch KN1, the first connection control switch KD1, the second connection control switch KD2, the second output switch KO2, the second selection switch KX2, the second output control switch KS2, the fourth selection switch KX4, the third output switch KO3, the fourth output switch KO4, the third connection control switch KD3, the fourth connection control switch KD4, the first control switch KC1, the second control switch KC2, the fifth control switch KC5, the sixth control switch KC6, the ninth control switch KC9, and the tenth control switch KC10 are all turned on, while the second input switch KN2, the first selection switch KX1, the second selection switch KX2, the third selection switch KX3, the fourth selection switch KX4, the first output control switch KS1, the third control switch KC3, the fourth control switch KC4, the seventh control switch KC7, and the eighth control switch KC8 are all turned off. In this case, the voltage at the first power supply end VSS is input to the first signal output end VOUT1, to pull down the first signal output end VOUT1 to 0 V, and the voltage at the second power supply end VDDH is input to the second signal output end VOUT2, to pull up the second signal output end VOUT2 to 1.8 V.

In a t2 phase, the second input switch KN2, the third connection control switch KD3, the fourth connection control switch KD4, the fourth output switch KO4, the fourth selection switch KX4, the first output control switch KS1, the second selection switch KX2, the second output switch KO2, the first output switch KO1, the first control switch KC1, the fourth control switch KC4, the fifth control switch KC5, the sixth control switch KC6, the seventh control switch KC7, and the tenth control switch KC10 are all turned on, while the first input switch KN1, the first selection switch KX1, the second selection switch KX2, the third selection switch KX3, the fourth selection switch KX4, the second output control switch KS2, the second control switch KC2, the third control switch KC3, the eighth control switch KC8, and the ninth control switch KC9 are all turned off. In this case, the voltage at the first power supply end VSS is input to the second signal output end VOUT2, to pull down the second signal output end VOUT2 to 0 V, and the voltage at the second power supply end VDDH is input to the first signal output end VOUT1, to pull up the first signal output end VOUT1 to 1.8 V.

Then, an operating process of the level shifting circuit 212 may be repeating operations in the t1 phase and the t2 phase. Details are not described herein.

It can be learned from the foregoing embodiments that when the voltage input to the second power supply end VDDH is less than or equal to the upper limit of the withstand voltage range of the single switch, the level shifting circuit 212 in this embodiment of this application is applicable.

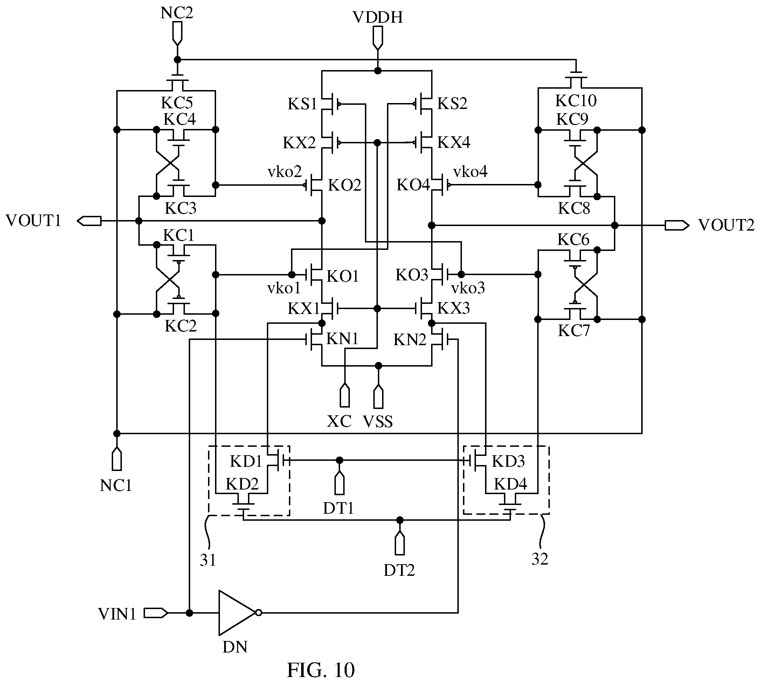

To reduce a quantity of external ports connected to the level shifting circuit 212 and reduce routing difficulty, in this embodiment of this application, a phase inverter DN may be further disposed in the level shifting circuit 212, and a quantity of input ends is reduced by using the phase inverter DN. For example, FIG. 10 is a schematic of another specific circuit structure of the level shifting circuit according to an embodiment of this application. A first signal input end VIN1 and an input end of the phase inverter DN may be connected to a same port, a second signal input end VIN2 is connected to an output end of the phase inverter DN, and a first signal output end VOUT1 and a second signal output end VOUT2 are connected to different ports. In addition, for an operating process of the level shifting circuit 212 shown in FIG. 10, refer to the content in the foregoing embodiments. Details are not described herein again.

The foregoing content is merely specific implementations of this application, but is not intended to limit the protection scope of this application. Any variation or replacement readily figured out by a person skilled in the art within the technical scope disclosed in this application shall fall within the protection scope of this application.

## Claims

1. A level shifting circuit, comprising an input/output circuit and a withstand voltage control circuit, wherein
the input/output circuit comprises a first input switch, a second input switch, a first output control switch, a second output control switch, a first output switch, a second output switch, a third output switch, a fourth output switch, a first selection switch, a second selection switch, a third selection switch, and a fourth selection switch, wherein a control electrode of the first input switch is connected to a first signal input end, a first electrode of the first input switch is connected to a first power supply end, a second electrode of the first input switch is connected to a first electrode of the first selection switch, a second electrode of the first selection switch is connected to a first electrode of the first output switch, a control electrode of the first output control switch is configured to receive a first output control signal, a first electrode of the first output control switch is connected to a second power supply end, a second electrode of the first output control switch is connected to a first electrode of the second selection switch, a second electrode of the second selection switch is connected to a first electrode of the second output switch, a second electrode of the first output switch and a second electrode of the second output switch are both connected to a first signal output end, a control electrode of the second input switch is connected to a second signal input end, a first electrode of the second input switch is connected to the first power supply end, a second electrode of the second input switch is connected to a first electrode of the third selection switch, a second electrode of the third selection switch is connected to a first electrode of the third output switch, a control electrode of the second output control switch is configured to receive a second output control signal, a first electrode of the second output control switch is connected to the second power supply end, a second electrode of the second output control switch is connected to a first electrode of the fourth selection switch, a second electrode of the fourth selection switch is connected to a first electrode of the fourth output switch, a second electrode of the third output switch and a second electrode of the fourth output switch are both connected to a second signal output end, and a control electrode of the first selection switch, a control electrode of the second selection switch, a control electrode of the third selection switch, and a control electrode of the fourth selection switch are all connected to a selection control end;
for the withstand voltage control circuit, a first input end is connected to a first withstand voltage control end, a second input end is connected to the first signal output end, a third input end is connected to the second signal output end, a first output end is connected to a control electrode of the first output switch, a second output end is connected to a control electrode of the second output switch, a third output end is connected to a control electrode of the third output switch, and a fourth output end is connected to a control electrode of the fourth output switch; and
the withstand voltage control circuit is configured to: output a voltage at the first withstand voltage control end or the first signal output end to the control electrode of the first output switch, output the voltage at the first withstand voltage control end or the first signal output end to the control electrode of the second output switch, output the voltage at the first withstand voltage control end or the second signal output end to the control electrode of the third output switch, and output the voltage at the first withstand voltage control end or the second signal output end to the control electrode of the fourth output switch.

2. The level shifting circuit according to claim 1, wherein the withstand voltage control circuit comprises a first withstand voltage control sub-circuit, a second withstand voltage control sub-circuit, a third withstand voltage control sub-circuit, and a fourth withstand voltage control sub-circuit;
for the first withstand voltage control sub-circuit, a first input end is connected to the first withstand voltage control end, a second input end is connected to the first signal output end, and an output end is connected to the control electrode of the first output switch; and the first withstand voltage control sub-circuit is configured to output the voltage at the first withstand voltage control end or the first signal output end to the control electrode of the first output switch in response to voltages at the first withstand voltage control end and the first signal output end;
for the second withstand voltage control sub-circuit, a first input end is connected to the first withstand voltage control end, a second input end is connected to the first signal output end, and an output end is connected to the control electrode of the second output switch; and the second withstand voltage control sub-circuit is configured to output the voltage at the first withstand voltage control end or the first signal output end to the control electrode of the second output switch in response to the voltages at the first withstand voltage control end and the first signal output end;
for the third withstand voltage control sub-circuit, a first input end is connected to the first withstand voltage control end, a second input end is connected to the second signal output end, and an output end is connected to the control electrode of the third output switch; and the third withstand voltage control sub-circuit is configured to output the voltage at the first withstand voltage control end or the second signal output end to the control electrode of the third output switch in response to voltages at the first withstand voltage control end and the second signal output end; and
for the fourth withstand voltage control sub-circuit, a first input end is connected to the first withstand voltage control end, a second input end is connected to the second signal output end, and an output end is connected to the control electrode of the fourth output switch; and the fourth withstand voltage control sub-circuit is configured to output the voltage at the first withstand voltage control end or the second signal output end to the control electrode of the fourth output switch in response to the voltages at the first withstand voltage control end and the second signal output end.

3. The level shifting circuit according to claim 2, wherein the first withstand voltage control sub-circuit comprises a first control switch and a second control switch;
a control electrode of the first control switch is connected to the first withstand voltage control end, a first electrode of the first control switch is connected to the first signal output end, and a second electrode of the first control switch is connected to the control electrode of the first output switch; and
a control electrode of the second control switch is connected to the first signal output end, a first electrode of the second control switch is connected to the first withstand voltage control end, and a second electrode of the second control switch is connected to the control electrode of the first output switch.

4. The level shifting circuit according to claim 2 or 3, wherein the second withstand voltage control sub-circuit comprises a third control switch and a fourth control switch;
a control electrode of the third control switch is connected to the first withstand voltage control end, a first electrode of the third control switch is connected to the first signal output end, and a second electrode of the third control switch is connected to the control electrode of the second output switch; and
a control electrode of the fourth control switch is connected to the first signal output end, a first electrode of the fourth control switch is connected to the first withstand voltage control end, and a second electrode of the fourth control switch is connected to the control electrode of the second output switch.

5. The level shifting circuit according to claim 4, wherein the second withstand voltage control sub-circuit further comprises a fifth control switch; and
a control electrode of the fifth control switch is connected to a second withstand voltage control end, a first electrode of the fifth control switch is connected to the first withstand voltage control end, and a second electrode of the fifth control switch is connected to the control electrode of the second output switch.

6. The level shifting circuit according to any one of claims 2 to 5, wherein the third withstand voltage control sub-circuit comprises a sixth control switch and a seventh control switch;
a control electrode of the sixth control switch is connected to the first withstand voltage control end, a first electrode of the sixth control switch is connected to the second signal output end, and a second electrode of the sixth control switch is connected to the control electrode of the third output switch; and
a control electrode of the seventh control switch is connected to the second signal output end, a first electrode of the seventh control switch is connected to the first withstand voltage control end, and a second electrode of the seventh control switch is connected to the control electrode of the third output switch.

7. The level shifting circuit according to any one of claims 2 to 6, wherein the fourth withstand voltage control sub-circuit comprises an eighth control switch and a ninth control switch;
a control electrode of the eighth control switch is connected to the first withstand voltage control end, a first electrode of the eighth control switch is connected to the second signal output end, and a second electrode of the eighth control switch is connected to the control electrode of the fourth output switch; and
a control electrode of the ninth control switch is connected to the second signal output end, a first electrode of the ninth control switch is connected to the first withstand voltage control end, and a second electrode of the ninth control switch is connected to the control electrode of the fourth output switch.

8. The level shifting circuit according to claim 7, wherein the fourth withstand voltage control sub-circuit further comprises a tenth control switch; and
a control electrode of the tenth control switch is connected to the second withstand voltage control end, a first electrode of the tenth control switch is connected to the first withstand voltage control end, and a second electrode of the tenth control switch is connected to the control electrode of the fourth output switch.

9. The level shifting circuit according to any one of claims 1 to 8, wherein the level shifting circuit further comprises a first connection control circuit and a second connection control circuit;
an input end of the first connection control circuit is connected to the second electrode of the first input switch, an output end of the first connection control circuit is connected to the control electrode of the first output switch, and the first connection control circuit is configured to control connection or disconnection between the second electrode of the first input switch and the control electrode of the first output switch; and
an input end of the second connection control circuit is connected to the second electrode of the second input switch, an output end of the second connection control circuit is connected to the control electrode of the third output switch, and the second connection control circuit is configured to control connection or disconnection between the second electrode of the second input switch and the control electrode of the third output switch.

10. The level shifting circuit according to claim 9, wherein the first connection control circuit comprises a first connection control switch and a second connection control switch;
a control electrode of the first connection control switch is connected to a first connection control end, a first electrode of the first connection control switch is connected to the second electrode of the first input switch, and a second electrode of the first connection control switch is connected to a first electrode of the second connection control switch; and
a control electrode of the second connection control switch is connected to a second connection control end, and a second electrode of the second connection control switch is connected to the control electrode of the first output switch.

11. The level shifting circuit according to claim 9 or 10, wherein the second connection control circuit comprises a third connection control switch and a fourth connection control switch;
a control electrode of the third connection control switch is connected to the first connection control end, a first electrode of the third connection control switch is connected to the second electrode of the second input switch, and a second electrode of the third connection control switch is connected to a first electrode of the fourth connection control switch; and
a control electrode of the fourth connection control switch is connected to the second connection control end, and a second electrode of the fourth connection control switch is connected to the control electrode of the third output switch.

12. The level shifting circuit according to any one of claims 1 to 11, wherein the control electrode of the first output control switch is connected to the control electrode of the third output switch, and the control electrode of the second output control switch is connected to the control electrode of the first output switch.

13. The level shifting circuit according to any one of claims 1 to 12, wherein the first signal input end and the second signal input end are connected to different ports, and the first signal output end and the second signal output end are connected to different ports.

14. The level shifting circuit according to any one of claims 1 to 12, wherein the level shifting circuit further comprises a phase inverter, the first signal input end and an input end of the phase inverter are connected to a same port, and the second signal input end is connected to an output end of the phase inverter; and
the first signal output end and the second signal output end are connected to different ports.

15. A chip, comprising an input end circuit, an output end circuit, and at least one level shifting circuit according to any one of claims 1 to 14, wherein
an input end of the level shifting circuit is connected to the input end circuit, and is configured to receive an input voltage from the input end circuit; and
an output end of the level shifting circuit is connected to the output end circuit, and is configured to send an output voltage to the output end circuit.

16. An electronic device, comprising a circuit board and the chip according to claim 15, wherein
the chip is disposed on the circuit board.
